# EUROPÄISCHE PATENTSCHRIFT

(11) **EP 1 507 887 B1**
(45) Veröffentlichungstag und Bekanntmachung des Hinweises auf die Patenterteilung: **09.07.2008**
(21) Anmeldenummer: 03737973.2
(22) Anmeldetag: 26.05.2003
(51) Int. Cl.: C23C 16/04, C23C 16/50, B05D 7/24, C03C 17/00

(54) **MEHRPLATZ-BESCHICHTUNGSVORRICHTUNG UND VERFAHREN ZUR PLASMABESCHICHTUNG**
MULTISTATION COATING DEVICE AND METHOD FOR PLASMA COATING
DISPOSITIF COMPRENANT DE MULTIPLES EMPLACEMENTS POUR L'APPLICATION DE REVETEMENT MULTIPLACE ET PROCEDE DE REVETEMENT PAR PLASMA

(30) Priorität: 24.05.2002 DE 10223288; 01.06.2002 DE 10224395; 07.06.2002 DE 10225607; 07.06.2002 DE 10225609; 16.11.2002 DE 10253513; 16.11.2002 DE 10253512
(43) Veröffentlichungstag der Anmeldung: 23.02.2005
(73) Patentinhaber: Schott AG, 55122 Mainz (DE)
(72) Erfinder: BEHLE, Stephan, 55239 Gau-Odernheim (DE); LÜTTRINGHAUS-HENKEL, Andreas, 64289 Darmstadt (DE); ARNOLD, Gregor, 55294 Bodenheim (DE); BICKER, Matthias, 55126 Mainz (DE); WALTHER, Marten, 31061 Alfeld (DE); Dr.Jürgen Klein, 55127 Mainz (DE)
(74) Vertreter: Herden, Andreas F.
(86) Internationale Anmeldenummer: PCT/EP2003/005497
(87) Internationale Veröffentlichungsnummer: WO 2003/100121

(56) Entgegenhaltungen:
- WO-A-00/58631
- WO-A-01/31680
- WO-A-95/22413
- WO-A-99/17334
- US-A- 5 324 361

## Beschreibung

Die Erfindung betrifft eine Beschichtungsvorrichtung und ein Verfahren zur Plasmabeschichtung von Werkstücken, insbesondere eine Beschichtungsvorrichtung mit mehreren Beschichtungsplätzen und ein Verfahren zur gleichzeitigen Beschichtung mehrerer Werkstücke.

Die Barriereeigenschaften von Kunststoffbehältern wie etwa Kunststoffflaschen können durch Barriereschichten auf der Innen- oder Außenoberfläche solcher Behälter erheblich verbessert werden. Auf diese Weise können beispielsweise Lebensmittel vor den Einwirkungen von Sauerstoff geschützt werden, welcher durch die meisten Kunststoffarten verhältnismäßig gut hindurchdiffundiert.

Derartige Beschichtungen können unter anderem mittels verschiedener CVD-Verfahren (CVD: "Chemical Vapor Deposition", chemische Dampfphasenabscheidung) auf den Behälterwandungen abgeschieden werden. Das Plasma wird dazu im allgemeinen bei niedrigem Druck in einer Gasatmosphäre gezündet, welches einen Precursor-Gas aufweist. Die im Plasma entstehenden Reaktionsprodukte schlagen sich dann auf dem zu behandelnden Werkstück als Beschichtung nieder. Die für die Zündung des Plasmas notwendige Niederdruckatmosphäre erfordert es, die Umgebung des Werkstücks zu evakuieren. Dies kann beispielsweise durch geeignete Schleusen geschehen, oder auch indem das Werkstück in den Reaktorraum unter Normaldruck eingebracht und dieser dann anschließend evakuiert wird. Die Gestaltung der Überführung des Werkstücks von einer Normaldruck-Atmosphäre in eine Niederdruckatmosphäre oder ein Vakuum ist dementsprechend ein Kernproblem hinsichtlich der Prozeßgeschwindigkeit und der Kosten für eine CVD-Beschichtung.

Aus der WO 01/31680 A1 ist eine Vorrichtung für die Niederdruck-Plasmabehandlung von Behältern bekannt, bei welcher die Behandlungsstation einen feststehenden Hohlraum beinhaltet, welcher mit einem abnehmbaren Deckel verschlossen und geöffnet werden kann, wobei der Deckel einen Verbindungskanal aufweist, der in geschlossenem Zustand der Behandlungsstation eine Verbindung zu einem Vakuumkreislauf herstellt. Dabei werden die zu beschichtenden Behälter in den feststehenden Hohlraum eingesetzt und dann der Deckel verschlossen, woraufhin der Hohlraum evakuiert werden kann.

Diese Konstruktion ist jedoch insofern nachteilig, als der zu beschichtende Behälter mit einer komplizierten Bewegung entlang zweier zueinander senkrechter Richtungen in den Hohlraum befördert werden muß. Zudem ist der Behälter im Hohlraum bis auf die in geschlossenem Zustand vom Deckel abgedeckte Öffnung allseitig von den Hohlraumwandungen umgeben und läßt sich so nach erfolgter Beschichtung für eine Weiterbeförderung nur schwer greifen. Weiterhin ist der mögliche Durchsatz durch eine derartige Vorrichtung begrenzt, da der Bewegungsablauf für jeden einzelnen Behälter pro Beschichtungsvorgang wiederholt werden muß.

Der Erfindung liegt daher die Aufgabe zugrunde, eine Beschichtungsvorrichtung und ein Verfahren bereitzustellen, mit welchen die Beförderung von Werkstücken aus und in den Beschichtungsreaktor vereinfacht und ein großer Durchsatz ermöglicht wird. Diese Aufgabe wird bereits in überraschend einfacher Weise durch eine Beschichtungsvorrichtung gemäß Anspruch 1, eine Beschichtungsanlage gemäß Anspruch 19, sowie ein Verfahren zur Plasmabeschichtung von Werkstücken gemäß den Ansprüchen 34 und 46 gelöst. Vorteilhafte Weiterbildungen sind Gegenstand der Unteransprüche.

Dementsprechend umfaßt eine erfindungsgemäße Beschichtungsvorrichtung oder Plasmastation zur Plasmabeschichtung von Werkstücken mit
- einen Reaktor oder eine Plasmakammer mit einem beweglichen Hülsenteil und einem Sockelelement, wobei zwischen Hülsenteil und Sockelelement in aneinandergefügter Position zumindest eine abgedichtete Beschichtungskammer oder Kavität definiert, beziehungsweise gebildet wird, sowie
- einer Einrichtung zur Einleitung elektromagnetischer Energie in die zumindest eine Beschichtungskammer. Der Reaktor weist außerdem zumindest zwei Beschichtungsplätze auf. Auf diese Weise wird es erreicht, daß zumindest zwei Werkstücke gleichzeitig zugeführt, beschichtet und wieder herausgenommen werden können. Die erfindungsgemäße Anordnung mit beweglichem Hülsenteil erleichtert dabei den Bewegungsablauf für das Einsetzen und Herausnehmen der Werkstücke.
   Das erfindungsgemäße Verfahren zur Plasmabeschichtung von Werkstücken, welches insbesondere in einer erfindungsgemäßen Vorrichtung mit einem Reaktor mit einem beweglichen Hülsenteil und einem Sockelelement durchgeführt werden kann, sieht entsprechend vor,
- zumindest zwei zu beschichtende Werkstücke auf dem Sockelelement anzuordnen,
- das Hülsenteil mit dem Sockelelement durch Bewegen des Hülsenteils zusammenzufügen, so daß in aneinander- oder zusammengefügter Position zumindest eine abgedichtete Beschichtungskammer zwischen Hülsenteil und Sockelelement definiert oder gebildet wird, in welcher sich wenigstens eines der Werkstücke befindet,
- die Beschichtungskammer zu evakuieren,
- Prozeßgas einzuleiten, und
- ein Plasma durch Einleiten elektromagnetischer Energie zu erzeugen.

Dadurch, daß der Beschichtungsvorgang gleichzeitig für zwei oder mehr Werkstücke durchgeführt wird, kann der Durchsatz mit der Vorrichtung um einen entsprechenden Faktor erhöht werden. Da das Hülsenteil beweglich gegenüber einem feststehenden Sockelelement ausgeführt ist, sind die Beschichtungsplätze für die Werkstücke gut zugänglich. Die Werkstücke müssen aufgrund des beweglichen Hülsenteils nicht in dieses eingeführt werden, sondern können in einfacher Weise an oder auf dem Sockelelement angeordnet werden, wobei sich Hülsenteil dann beim Schließen über die Werkstücke stülpt.

Die Erfindung erlaubt außerdem eine Konstruktion einer Beschichtungsvorrichtung mit geringen bewegten Massen, da lediglich das Hülsenteil bewegt werden muß.

Vorteilhaft kann das Hülsenteil zum Öffnen und Verschließen der Beschichtungskammer im wesentlichen senkrecht mittels einer entsprechenden Führung des Hülsenteils zum Sockelelement bewegt werden, um eine möglichst freie Zugänglichkeit zu den Beschichtungsplätzen zu schaffen.

Gemäß einer Ausführungsform der Erfindung hat das Sockelelement dabei die Gestalt einer Grundplatte.

Besonders vorteilhaft ist es außerdem, wenn das Sockelelement Versorgungskanäle aufweist und durch diese das Bereitstellen von Betriebsmitteln erfolgt. Das Bereitstellen von Betriebsmitteln in diesem Sinne umfaßt insbesondere das Evakuieren und/oder die Belüftung und/oder das Zuführen von Prozessgas durch die Versorgungskanäle. Da das Sockelelement beim Öffnen und Schließen des Reaktors bezüglich der Beschichtungsvorrichtung in Ruhe bleibt, können auf diese Weise dynamische, beziehungsweise bewegte Vakuumverbindungen, wie zum Beispiel Wellschläuche, und bewegte Dichtungen weitestgehend vermieden werden. Gerade diese Anordnung ermöglicht eine robuste, wartungsarme Konstruktion mit wenigen beweglichen Teilen- Außerdem können so Ventile, die zur Steuerung und Schaltung der Gaszuflüsse und Abfuhren eingesetzt werden, direkt am oder nahe beim Sockelelement und nahe bei den Beschichtungskammern angeordnet werden. Daraus ergibt sich ein geringes Totvolumen.

Gemäß einer ersten Ausführungsform werden zumindest zwei voneinander getrennte Beschichtungskammern zwischen Hülsenteil und Sockelelement definiert. Durch getrennte Beschichtungskammern können sich die in den einzelnen Beschichtungsplätzen gezündeten Plasmen nicht gegenseitig beeinflussen und stören.

Es ist aber gemäß einer weiteren Ausführungsform der Erfindung auch möglich, eine gemeinsame Beschichtungskammer für zumindest zwei Beschichtungsplätze vorzusehen. Dies kann beispielsweise dann vorteilhaft sein, wenn die Werkstücke in einem gemeinsamen Plasma beschichtet werden.

Die Einrichtung zur Einleitung elektromagnetischer Energie weist bevorzugt wenigstens einen Zuführungsleiter auf, welcher die elektromagnetischen Felder in die Beschichtungskammer leitet. Dieser kann zum Beispiel in eine Öffnung im Hülsenteil eingreifen. Zur Abdichtung der Öffnung kann deren Rand und/oder der Leiter, etwa an einem Dichtungskragen mit einer Dichtung versehen sein.

Für das Zünden und Aufrechterhalten des Plasmas werden im allgemeinen Mikrowellen oder Hochfrequenzfelder verwendet. Um diese Wellen transportieren zu können, umfaßt der zumindest eine Zuführungsleiter bevorzugt einen Hohlleiter und/oder einen Koaxialleiter.

Vorteilhaft kann das Hülsenteil zum Öffnen und Schließen der Beschichtungskammer entlang des oder der Zuführungsleiter beweglich ausgestaltet sein, beziehungsweise zum Öffnen und Schließen entlang des Zuführungsleiters zur Zuführung elektromagnetischer Energie bewegt werden. Auf diese Weise kann der Zuführungsleiter gleichzeitig als Führung für das Hülsenteil dienen.

Bevorzugt kann ferner die Einrichtung zur Einleitung elektromagnetischer Energie außerdem zumindest eine Einrichtung zur Erzeugung von elektromagnetischer Energie umfassen. Die für die Plasmaerzeugung verwendeten Felder werden so direkt in der Beschichungsvorrichtung erzeugt, so daß eine Zuführung von Mikrowellen oder Hochfrequenzwellen, die unter Umständen über schlecht handhabbare flexible Leiter geschehen müßte, entfallen kann. Dies ist insbesondere dann von Vorteil, wenn die Beschichtungsvorrichtung auf einer Transporteinrichtung einer Beschichtungsanlage, beziehungsweise eines Plasmamoduls bewegt wird.

Vorzugsweise umfaßt das Einleiten elektromagnetischer Energie das Einleiten von Mikrowellen, um große Energiemengen in das Plasma einbringen zu können. Dazu kann die Einrichtung zur Erzeugung von elektromagnetischer Energie vorteilhaft zumindest einen Mikrowellenkopf umfassen. Dieser kann beispielsweise ein Magnetron als Mikrowellenquelle aufweisen. Besonders geeignet ist für die vom Mikrowellenkopf erzeugten Mikrowellen dabei eine Frequenz von 2,45 GHz.

Mit Vorteil kann die Einrichtung zur Einleitung elektromagnetischer Energie außerdem auch eine Einrichtung zur Aufteilung der elektromagnetischen Energie, beispielsweise in Form einer Hohlleiter- oder Impedanzstruktur umfassen. Mit einer solchen Einrichtung kann die von einer Quelle erzeugte Energie auf mehrere Beschichtungsplätze oder Beschichtungskammern verteilt werden. Eine solche Einrichtung kann beispielsweise eine Hohlleiter- oder Impedanzstruktur umfassen, wie sie in der früheren deutschen Patentanmeldung mit der Nummer 101 38 693.1-52, deren Offenbarung vollständig auch zum Gegenstand dieser Anmeldung gemacht wird, beschrieben ist

Bei einer bevorzugten Ausführungsform der Erfindung wird ein gepulstes Plasma durch Zuführen gepulster elektromagnetischer Energie erzeugt. Dementsprechend umfaßt die Einrichtung zur Erzeugung von elektromagnetischer Energie bei dieser Ausführungsform der Erfindung eine Einrichtung zur Erzeugung gepulster elektromagnetischer Energie. Mittels gepulster elektromagnetischer Energie läßt sich ein gepulstes Plasma zur Anwendung des Plasmaimpuls-CVD- oder PICVD-Verfahrens (PICVD=Pulse Induced Chemical Vapor Deposition als Beschichtungsverfahren erzeugen. Gegenüber der plasmaunterstützten chemischen Dampfphasenabscheidung (PECVD), bei welcher das Plasma kontinuierlich aufrechterhalten wird, ist das PICVD-Verfahren unter anderem deshalb vorteilhaft, weil sich mit diesem Verfahren die Aufheizung der temperaturempfindlichen Kunststoffe reduzieren läßt. Außerdem wird während der Zeitphasen außerhalb der Pulse, in denen kein Plasma angeregt ist, ein Gasaustausch ermöglicht. Dies führt zu besonders reinen Schichten, da unerwünschte Reaktionsprodukte in den Pulspausen abgeführt und neues Precursor-Gas zugeführt werden können.

Eine Hauptanwendung der erfindungsgemäßen. Vorrichtung liegt in der Beschichtung hohlkörperförmiger Werkstücke, wobei dazu die Beschichtungsplätze vorteilhaft zur Aufnahme solcher Werkstücke ausgebildet sein können. Die Beschichtungsplätze können dabei insbesondere zur Aufnahme von Flaschen, Ampullen, Kalotten oder Glühbirnenkörpern ausgebildet sein. Ebenso ist aber auch eine Beschichtung massiver Körper, wie etwa massiver Kunststoff-Formteile mit der Beschichtungsvorrichtung möglich.

Eine Ausführungsform der Erfindung sieht vor, daß das Evakuieren der Beschichtungskammer schrittweise in zumindest zwei Druckstufen erfolgt. Dies hat sich für einen schnellen Abpumpvorgang als günstig erwiesen, da auf diese Weise das evakuieren in den einzelnen Druckstufen effizienter wird.

Die erfindungsgemäße Vorrichtung kann insbesondere auch zur Innenbeschichtung hohlkörperförmiger Werkstücke ausgelegt sein. Demgemäß wird nach der Evakuierung in den Innenraum Prozeßgas eingeleitet, so daß es bei Einstrahlung oder Zuführung elektromagnetischer Energie dort zu einer Zündung eines Plasmas und dem Abscheiden einer Beschichtung an den Innenwandungen der Werkstücke kommt. Dazu ist es auch von Vorteil, wenn die Beschichtungsplätze Dichtungen zur Abdichtung des Innenraums der hohlkörperförmigen Werkstücke aufweisen. Durch die Abdichtung des Innenraums von der Umgebung wird die Möglichkeit geschaffen, im Innenraum der Werkstücke und deren Umgebung unterschiedliche Atmosphären und/oder Drücke bereitzustellen. Beispielsweise kann die Umgebung des Werkstücks und dessen Innenraum simultan evakuiert werden, wobei der Innenraum bis zu einem Basisdruck, typischerweise < 0,1mbar, insbesondere im Bereich von 0,05 bis 0,8 mbar, evakuiert wird und die Umgebung des Werkstücks entweder i) ebenfalls unterhalb des Basisdrucks oder ii) auf einen festen Außendruck im Bereich von 1 bis 100 mbar, insbesondere im Bereich von 10 und 100mbar abgepumpt wird.

Anschließend kann beispielsweise im Innenraum das Prozessgas eingefüllt werden. Für eine reine Innenbeschichtung wird entsprechend nur dem Innenraum Prozeßgas zugeführt. Auf diese Weise kann beispielsweise selektiv nur im Innenraum ein Plasma erzeugt werden, da die Gasdichte in der Umgebung für die Plasmabildung nicht ausreicht.

Um solche separat kontrollierbaren atmosphärische Bedingungen schaffen zu können, ist es von Vorteil, wenn beispielsweise das Sockelelement separate Versorgungskanäle zur Evakuierung und/oder Belüftung und/oder Zuführung von Prozessgas für den Innenraum und die Umgebung der hohlkörperförmigen Werkstücke aufweist. Dabei können auch beispielsweise die Versorgungskanäle zwei oder mehrerer Beschichtungsplätze über gemeinsame weitere versorgungskanäle oder Versorgungsleitungen zusammengeschaltet sein. Dies reduziert die effektive Gesamtlänge und Wandfläche der Versorgungskanäle und erhöht dadurch die Pumpleistung und den Gasdurchfluss.

Ebenso günstig für den Gasdurchfluss, hier speziell für den Durchfluss von Prozessgas ist es, wenn die Zuführung oder Einleitung von Prozessgas in eine Beschichtungskammer über zumindest eine Gaslanze erfolgt. Die Gaslanze kann so angeordnet sein, dass sich deren eine oder mehrere Öffnung sich im Plasma befinden. Auf diese Weise werden die Transportwege des Precursorgases im Plasma kurz gehalten, so dass es sich in möglichst kurzer Zeit möglichst gleichmäßig verteilt.

Die Gaslanze kann herein- und herausfahrbar ausgestaltet sein. Dies ist beispielsweise bei Innenbeschichtungen von Hohlkörpern sinnvoll, wenn die Gaslanze in das Innere des hohlkörperförmigen Werkstücks hineinragt und so beim Einsetzen oder Herausnehmen behindern würde. In diesem Fall kann die Gaslanze aus dem Innenraum des Werkstücks vor dem Herausnehmen herausgezogen und nach dem Einsetzen eines weiteren Werkstücks wieder in dieses eingeführt werden.

In besonders einfacher Weise kann die Bewegung der Gaslanze und auch insbesondere des Hülsenteils über mechanische Steuerkurven vermittelt werden. Diese können an einer Beschichtungsanlage angebracht sein und beispielsweise die Bewegung von Hülsenteil und/oder Gaslanze über an diesen angebrachte Kurvenrollen vermitteln. Die Steuerung des Öffnungs- und Schließvorgangs eines Beschichtungsreaktors mit mechanischen Steuerkurven, sowie weitere konstruktive Details sind außerdem ausführlich in der deutschen Anmeldung mit der Nummer 102 28 898.4 beschrieben, deren Offenbarung vollumfänglich auch zum Gegenstand dieser Anmeldung gemacht wird.

Im folgenden wird die Erfindung näher anhand bevorzugter Ausführungsformen und unter Bezugnahme auf die beigefügten Zeichnungen beschrieben. Dabei verweisen gleiche Bezugszeichen auf gleiche oder ähnliche Teile.

Es zeigen:
- Fig. 1A: eine Querschnittansicht durch eine Ausführungsform der Erfindung,
- Fig. 1B: eine Variante der in Fig. 1A gezeigten Ausführungsform mit einzelnem Mikrowellenkopf zur gemeinsamen Versorgung der Beschichtungskammern,
- Fig. 2: eine weitere Variante der in Fig. 1A gezeigten Ausführungsform mit gemeinsamer Beschichtungskammer für zwei Beschichtungsplätze,
- Fig. 3: eine Querschnittansicht durch eine Ausführungsform der Erfindung mit Steuerung des Öffnungs- und Schließvorganges durch mechanische Steuerkurven,
- Fig. 4: eine schematische Aufsicht auf eine Beschichtungsanlage mit einer Vielzahl von erfindungsgemäßen Beschichtungsvorrichtungen,
- Fig. 5A und 5B: eine Schnittansicht und eine Aufsicht auf einen Dichtungsflansch einer Beschichtungsvorrichtung für hohlkörperförmige Werkstücke.

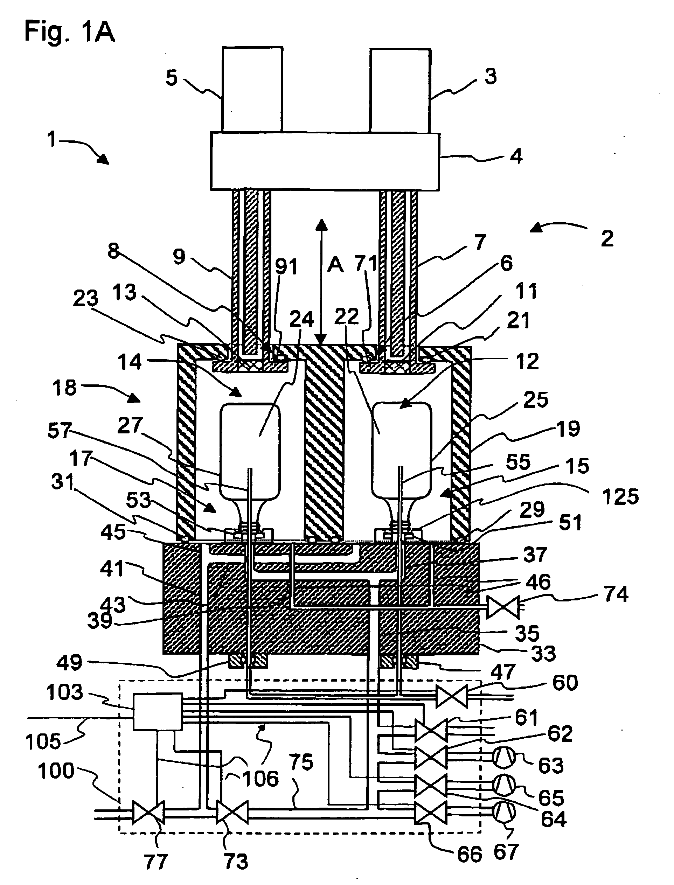

In Fig. 1A ist eine schematische Querschnittansicht durch eine Ausführungsform der erfindungsgemäßen Beschichtungsvorrichtung dargestellt, die als Ganzes mit 1 bezeichnet ist. Die Beschichtungsvorrichtung 1 umfasst einen Reaktor 18 mit einem Sockelelement 33, welches bei diesem Ausführungsbeispiel die Gestalt einer Grundplatte aufweist und einem beweglichen Hülsenteil 19, sowie eine Einrichtung 2 zur Einleitung elektromagnetischer Energie. Das bewegliche Hülsenteil 19 kann beispielsweise die Form einer zylinderförmigen Kammerwandung aufweisen.

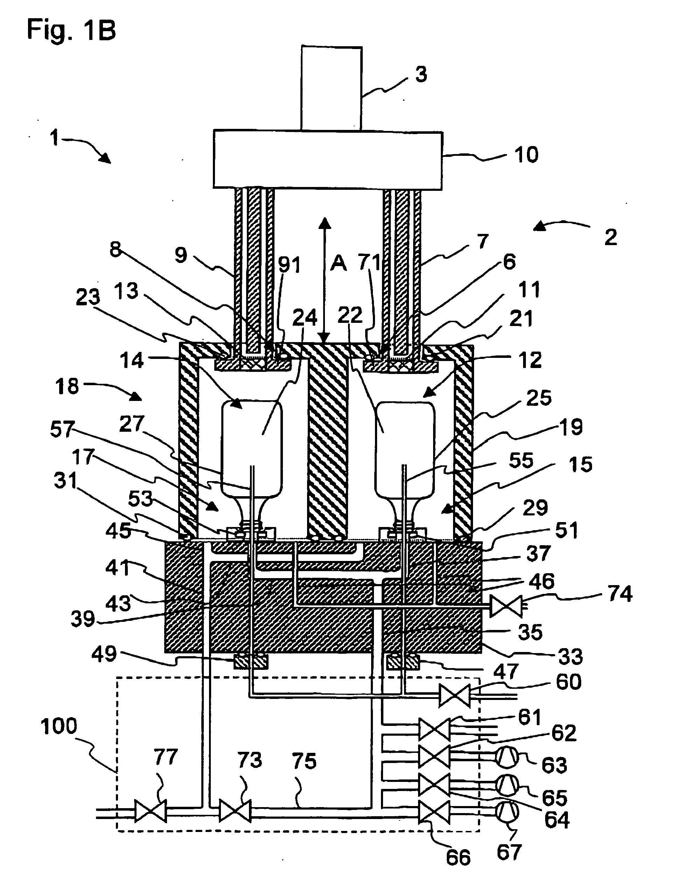

In aneinandergefügter Position, wie sie in Fig. 1 dargestellt ist, werden zwischen Hülsenteil 19 und Sockelelement 33 zwei abgedichtete Beschichtungskammern 15, 17 gebildet, welche jeweils einen Beschichtungsplatz 12, beziehungsweise 14 für ein Werkstück darstellen und in welche für die Beschichtung zum Zünden des Plasmas elektromagnetische Energie eingeleitet wird. Dementsprechend können bei der in Fig. 1 gezeigten Ausführungsform zwei Werkstücke gleichzeitig behandelt werden. Durch die Trennung der Kammern wird eine gegenseitige Beeinflussung der Plasmen während der Beschichtung vermieden. Die Abdichtung der Beschichtungskammern 15, 17 des Reaktors 2 gegenüber der Umgebung wird dazu durch Dichtungen 29 und 31 hergestellt, welche zwischen Sockelelement 33 und Hülsenteil 19 angeordnet sind.

Um Werkstücke 15 und 17, zu beschichten, werden diese auf dem Sockelelement 33 angeordnet, das Hülsenteil 19 anschließend mit dem Sockelelement 33 durch Bewegen des Hülsenteils 19 zusammengeführt, so daß in zusammengefügter Position beider Teile abgedichtete Beschichtungskammern 15, 17 zwischen Hülsenteil 19 und Sockelelement 33 definiert werden, in welchen sich die Werkstücke 25, 27 befinden. Die Beschichtungskammern 15, 17 werden dann evakuiert, Prozessgas wird eingeleitet, und schließlich wird ein Plasma durch Einleiten elektromagnetischer Energie erzeugt, so daß sich eine CVD-Beschichtung auf den an das Plasma angrenzenden Oberflächen der Werkstücke ausbildet.

Die Einrichtung 2 zur Einleitung elektromagnetischer Energie umfaßt außerdem eine Einrichtung zur Erzeugung elektromagnetischer Energie aus zwei Mikrowellenköpfen oder Mikrowellengeneratoren 3 und 5, einen Adapter in Form eines Rechteckhohlleiters 4 und zwei von diesem abzweigende Zuführungsleitungen, beziehungsweise Kopplungskanäle 7 und 9 auf, die bei der in Fig. 1 dargestellten Ausführungsform als Koaxialleiter ausgebildet sind. Die Mikrowellenköpfe erzeugen bevorzugt Mikrowellen mit der postalisch zugelassenen Frequenz 2,45 GHz.

Eine Variante der in Fig. 1A dargestellten Ausführungsform ist in Fig. 1B dargestellt. Diese Variante weist nur einen einzelnen Mikrowellenkopf 3 auf. Dabei sind beide Beschichtungskammern 15, 17 an den einzigen Mikrowellenkopf angeschlossen. Mittels einer Impedanzstruktur oder Hohlleiterstruktur 10, wie sie beispielsweise in der deutschen Patentanmeldung mit der Anmeldenummer 101 38 693.1-52 beschrieben ist, wird dann die Mikrowellenenergie auf die einzelnen Beschichtungskammern 15, 17 verteilt.

Das Hülsenteil 19 wird bei den in den Fig. 1A und 1B dargestellten Ausführungsformen zum Öffnen und Verschließen der Beschichtungskammer im wesentlichen senkrecht zum Sockelelement 33 entlang der Richtung A bewegt. Die Richtung A verläuft dabei entlang der Zuführungsleiter 7 und 9, so dass das Hülsenteil entlang der Zuführungsleiter beweglich ist. Die Leiter dienen dabei gleichzeitig als Führung für das Hülsenteil. Zum Öffnen und Schließen der Beschichtungskammern 15, 17 wird dementsprechend das Hülsenteil 19 bewegt, während das Sockelelement 33 festgehalten wird.

Das Hülsenteil 19 weist ferner Öffnungen 6 und 8 auf, in welche die Zuführungsleiter 7 und 9 der Einrichtung 2 zur Einleitung elektromagnetischer Energie eingreifen. Die Koaxialleiter, beziehungsweise Zuführungsleiter 7 und 9 sind mit Dichtungskragen 71 und 91 versehen, welche beim Schließen der Beschichtungskammern 15, 17 gegen Dichtungen 21 und 23 gepresst werden, die am Hülsenteil 19 angebracht sind und so die Beschichtungskammern 15 und 17 vakuumdicht verschließen. Die Koaxialleiter 7, 9 sind außerdem mit dielektrischen Fenstern 11 und 13, beispielsweise Quarzglasfenster für die Einkopplung der Mikrowellen in den Niederdruck- oder Vakuumbereich des Reaktors 18 versehen.

Die in den Fig. 1A und 1B gezeigten Ausführungsformen sind speziell für die Beschichtung von hohlkörperförmigen Werkstücken 25 und 27 ausgebildet, wobei in den Fig. 1A und 1B beispielhaft Flaschen als Werkstücke dargestellt sind. Das Sockelelement 33 weist Dichtflansche 125 mit Dichtungen 51 und 53 auf, welche an der Mündungsöffnung der Werkstücke das Innere der hohlkörperförmigen Werkstücke 25 und 27 gegenüber der Umgebung vakuumdicht abschließen. Damit können innen und außerhalb des Werkstücks unterschiedliche Drücke eingestellt werden, beispielsweise um eine reine Innenbeschichtung oder auch eine reine Außenbeschichtung oder unterschiedliche Beschichtungen im Innenraum und auf der Außenoberfläche der Werkstücke 25, 27 herstellen zu können.

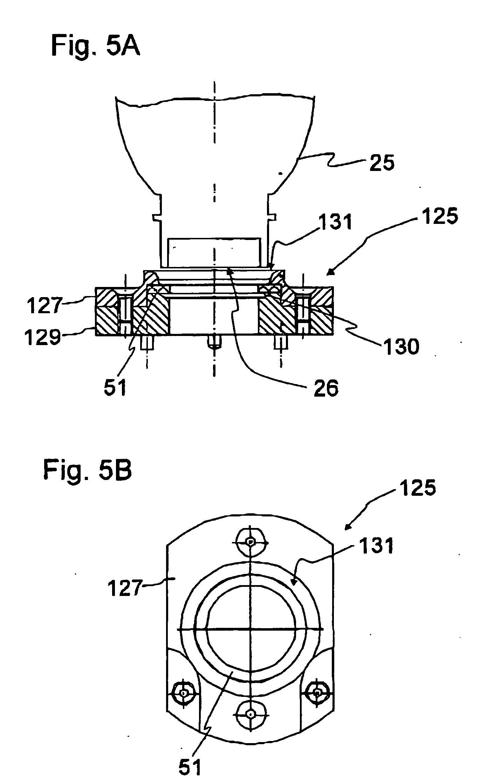

In den Fig. 5A und 5B ist ein Dichtflansch zur Abdichtung der Mündungsöffnung eines Werkstücks in Schnittdarstellung und Aufsicht gezeigt. Der Dichtflansch weist ein erstes Teil 127 und ein zweites Teil 129 auf, die miteinander verschraubt sind. Zwischen diesen beiden Teilen 127, 129 wird die Dichtung 51 durch das Zusammenschrauben geklemmt und so fixiert. Der Dichtflansch wird mit dem Teil 129 am Sockel 33 einer erfindungsgemäßen Beschichtungsvorrichtung 1 befestigt. Das Teil 127 weist eine Einführöffnung 131 auf, welche sich in Richtung entgegen der Einführrichtung des Werkstücks 25 erweitert, um das Einführen des Werkstücks zu erleichtern. Der Innendurchmesser der Einführöffnung 131 ist geringer als der Innendurchmesser der Dichtung 51. Beim Einführen des Werkstücks 25, wie insbesondere einer Flasche trifft so die Mündungsöffnung 26 des Werkstücks auf die Dichtung 51. Durch Anpressen des Werkstücks 25 an die Dichtung 51, beziehungsweise an den Dichtflansch 125 wird so eine Abdichtung des Innenraums gegenüber der Umgebung des Werkstücks 25 erreicht.

Vielfach weist ein typisches zu beschichtendes Werkstück, wie beispielsweise eine Kunststoff-Getränkeflasche keine besonders ebene Mündungsöffnung auf. Dies kann, sofern die Dichtung nicht hinreichend flexibel ist, zur Undichtigkeit führen. Um die Flexibilität er Dichtung 51 zu verbessern, weist dazu das Teil 129 eine Unterschneidung 130 in Form einer um den inneren Rand des Teiles 129 umlaufenden, ringförmigen Absenkung auf. In diesem Bereich kann die Dichtung 51 nachgeben und sich so der Form der Mündungsöffnung des Werkstücks 25 anpassen.

Für die Versorgung der Umgebung der Werkstücke in den Beschichtungskammern mit Prozeßgas für eine Außenbeschichtung können Versorgungskanäle 46 vorgesehen sein, welche in die Beschichtungskammern 15, 17 der Beschichtungsplätze 12, 14 einmünden und über ein Ventil 74 mit einer nicht dargestellten Gasversorgung verbunden sind. Nach der Evakuierung der Beschichtungskammern 15, 17 kann dann über die Kanäle 46 Prozeßgas auch der Umgebung der Werkstücke zugeführt und durch Zündung eines Plasmas in diesem Bereich auch eine äußere Beschichtung vorgenommen werden.

Um die Beschichtungskammern 15, 17 evakuieren und belüften zu können, sind in dem Sockelelement Versorgungskanäle 35, 37, 39, 41, 43 und 45 vorgesehen, wobei die Versorgungskanäle 43 und 45 als Kammeranschlußkanäle und die Versorgungskanäle 35, 37 als Werkstückanschlußkanäle dienen. Mit der Anordnung der Versorgungskanäle im feststehenden Teil des Reaktors, und zwar dem Sockelelement 33, werden dynamische Dichtungen oder bewegte Zuleitungen vermieden. Die versorgungskanäle 5, 37, 39, 41, 43 und 45 können dabei sowohl als Abpumpkanäle zur Evakuierung und Abfuhr von Prozeßgas, als auch als Belüftungskanäle zur Belüftung der Beschichtungskammern vor dem Herausnehmen der Werkstücke dienen.

Damit sich unterschiedlichen Drücke oder Gasatmosphären im Innenbereich und der Umgebung der Werkstücke herstellen lassen, weist das Sockelelement separate Versorgungskanäle zur Evakuierung und Belüftung für den Innenraum 22, 24 der Werkstücke einerseits und die Umgebung der hohlkörperförmigen werkstücke 25, 27 andererseits auf. Im einzelnen dienen dabei die Versorgungskanäle 43 und 45 zur Evakuierung und Belüftung der Umgebung und die Versorgungskanäle 37, 39 zur Evakuierung und Belüftung des Innenraums 22, 24 der Werkstücke 15, 17.

Ferner sind die Versorgungskanäle 43, 45 für die Umgebung und die Versorgungskanäle 37, 39 für den Innenbereich beider Beschichtungsplätze jeweils zusammengeschaltet und münden in einen gemeinsamen Versorgungskanal 41 für die Umgebung, beziehungsweise einen Versorgungskanal 35 für die Innenräume 22, 24 der Werkstücke.

Die Zuführung des Prozeßgases für die Innenbeschichtung der Werkstücke 25, 27 erfolgt über hohle Gaslanzen 55 und 57, die während der Beschichtung in das Innere der Werkstücke hineinragen. Diese sind bei der in Fig. 1A dargestellten Ausführungsform mittels dynamischer, am Sockelelement 33 angeordneter Dichtungen 47, beziehungsweise 49 gegenüber der Umgebung der Beschichtungsvorrichung 1 abgedichtet. Der Fluß des Prozeßgases wird durch ein Prozeßgasventil 60 ein- und ausgeschaltet. Das Ventil 60 kann auch zur kontinuierlichen Regelung des Prozeßgas-Flusses als Regelventil ausgebildet sein.

Anders als in den Fig. 1A und 1B dargestellt, kann die Beschichtungsvorrichtung 1 und/oder der Ventilblock 100 auch mehrere Prozeßgasventile aufweisen, beispielsweise ein Primär- und ein Sekundärprozeßgasventil. Durch die einzelnen Ventile können dann verschiedene Prozeßgase eingelassen oder einzelne Prozeßgaskomponenten zugeführt werden, um die Zusammensetzung der abgeschiedenen Beschichtung anpassen zu können. Auf diese Weise können beispielsweise vorteilhaft mehrlagige Beschichtungen mit Lagen unterschiedlicher Zusammensetzung auf den Werkstücken abgeschieden werden. Es kann unter anderem vorteilhaft sein, zunächst eine Haftvermittlerschicht und darauf eine Barriereschicht aufzubringen, um die Haltbarkeit der Beschichtung zu erhöhen und ein Ablösen zu verhindern.

Bei der in Fig. 1B dargestellten Ausführungsform der erfindungsgemäßen Vorrichtung sind die Dichtungen 47, 49 an den Gaslanzen 55, 57 befestigt und die Dichtungsringe der Dichtungen 47, 49 axial angeordnet, so daß die Gaslanze bei Aus- und Einfahren nicht am Dichtungsring reibt. Dementsprechend erfolgt hier keine dynamische Dichtung, sondern der Dichtring dichtet beim Hereinfahren der Gaslanze dann ab, wenn er in herangefahrener Position der Gaslanzen angedrückt wird.

An den Zuführungskanal 35 für die Evakuierung der Innenräume 22, 24 der Werkstücke 25, 27 sind außerdem Pumpeinrichtungen 63, 65 und 67 über Ventile 62, 64 und 66 angeschlossen. Dabei dient die Pumpeinrichtung 63 für die Abfuhr von Prozeßgas und das Ventil 62 entsprechend als Prozeßvakuumventil. Die Ventile 64 und 66 dienen als Sekundär- und Primärvakuumventile, welche sequentiell zum Abpumpen der Beschichtungskammern, beziehungsweise der Innenräume der hohlkörperförmigen Werkstücke geöffnet und geschlossen werden, um eine Evakuierung in mehreren Druckstufen zu realisieren. Die Pumpeinrichtungen 65 und 67 sind für die Evakuierung auf den zur Beschichtung erforderlichen Restgasdruck vorgesehen, wobei die Pumpeinrichtungen unterschiedliche Enddrücke erreichen können und zur Evakuierung und der Abfuhr von Prozeßgas nacheinander zu- und abgeschaltet werden, so daß ein mehrstufiges Pumpsystem realisiert wird. Selbstverständlich können aber auch einstufige Pumpsysteme oder Systeme mit noch mehr Stufen verwendet werden. Vorteilhaft kann die erste Pumpstufe unter Verwendung der Pumpeinrichtung 67 für eine Evakuierung ausgehend von Atmosphärendruck bis auf etwa 50 mBar ausgelegt sein. Als weitere Pumpstufe kann dann mittels der Pumpeinrichtung 65 dann ausgehend von dem mit der ersten Pumpstufe erreichten Druck bis auf den Basisdruck abgepumpt werden, der typischerweise in einem Bereich zwischen 0,05 bis 0,8 mbar liegt. Alternativ kann, insbesondere um nur eine Innenbeschichtung der Werkstücke vorzunehmen, der Innenraum 22, 24 der Werkstücke 15, 17 bis zu einem Basisdruck < 0,1 mbar und die Umgebung der Werkstücke 15, 17 auf einen festen Außendruck zwischen 1 und 100mbar abgepumpt werden. Auf diese Weise muß außen nicht der Basisdruck erreicht werden. Dadurch läßt sich unter anderem die Pumpzeit durch Verringern des Pumpvolumen nach Erreichen des Außendruck-Niveaus verkürzen, da ab diesem Punkt nur noch der Innenraum gepumpt werden braucht. Das Abpumpen vom Vorvakuum im Bereich von 10 mbar bis 100 mbar auf den Basisdruck kann auch vorteilhaft gemäß eines weiteren Ausführungsbeispiels unter Verwendung weiterer, in den Fig. 1A und 1B nicht dargestellter Pumpeinrichtungen und Ventile in feiner abgestuften Schritten oder Druckstufen erfolgen.

Schließlich wird einströmendes Prozeßgas mit einer dritten Pumpstufe mit der Pumpeinrichtung 63 abgesaugt und so ein Gasaustausch von Prozeßgas und eine Stabilisierung des Drucks in den Beschichtungskammern erreicht.

Der Versorgungskanal 41 ist ferner über eine mit einem als Kammervakuumventil dienendes Ventil 73, geschaltete Bypass-Leitung 75 mit dem Versorgungskanal 35 verbunden. Auf diese Weise können auch die Umgebungen der Werkstücke in den Beschichtungskammern 15, 17 evakuiert werden. Dazu wird während des Abpumpvorgangs mittels des Ventils 73 die Bypass-Leitung 75 geöffnet, so daß die Pumpeinrichtungen 65 und 67 über diese Leitung mit den Versorgungskanälen 43 und 45 verbunden werden. Nach Abschluß der Evakuierung werden dann die Ventile 73, 66 und 64 geschlossen und Prozeßgas strömt nach Öffnen des Ventils 60 über die Lanzen 55, 57 in die Innenräume der Werkstücke und wird nach Öffnen des Prozeßvakuumventils 62 durch die Pumpeinrichtung 63 kontinuierlich abgepumpt. Ferner strömt nach Zünden des Plasmas ständig frisches Gas über die Gaslanzen 55 und 57 und/oder die Kanäle 46 ein und verbrauchtes Gas und Reste von unverbrauchtem Prozessgas werden über das geöffnete Ventil 62 durch die Pumpeinrichtung 63 abgepumpt.

Nach abgeschlossener Beschichtung können dann durch Öffnen der Ventile 61 und 77 sowohl die Innenräume, als auch die umgebenden Beschichtungskammern 15, 17 belüftet werden. Daraufhin herrscht Normaldruck in den Beschichtungskammern und den Werkstücken und der Reaktor kann ohne großen Kraftaufwand geöffnet werden. Dabei dient das Ventil 61 als werkstückentlüftungsventil und das Ventil 77 als Kammerentlüftungsventil. Die Ventile sind 60, 61, 62, 64, 66, 73, 74, 77 in einem Ventilblock 100 zusammengefaßt, der ebenso wie die Beschichtungsvorrichtung 1 auf einer in den Fig. 1A und 1B nicht dargestellten Transporteinrichtung einer Beschichtungsanlage angeordnet ist. Über den Ventilblock 100 sind die Beschichtungskammern 15, 17 der Beschichtungsvorrichtung 1 mit den Zuleitungen zu den Pumpeinrichtungen 63, 65, 67, über das Ventil 650 mit einer Prozessgasquelle, sowie über das Ventil 77 zur Belüftung mit Umgebungsdruck verbunden.

Der Ventilblock 100 weist außerdem gemäß einer Weiterbildung der Erfindung eine wie in Fig. 1A schematisch dargestellte Pneumatik-Verteilungseinrichtung 103 auf. Diese verteilt Druckluft aus einer Druckluft-Zuleitung 105 über Verteilungsleitungen 106 auf die einzelnen Ventile. Auch die in Fig. 1B, sowie die anhand der folgenden Figuren erläuterten Ausführungsbeispiele können eine solche Pneumatik-Verteilungseinrichtung 103 aufweisen, diese ist jedoch vereinfachend dort nicht dargestellt.

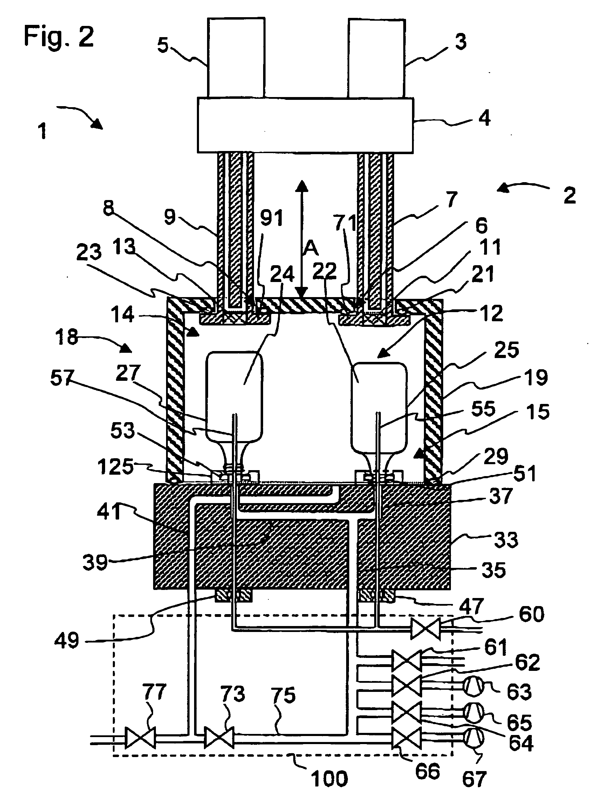

In Fig. 2 ist eine Variante der in Fig. 1 gezeigten Ausführungsform dargestellt. Bei dieser Variante ist im Unterschied zu der anhand von Fig. 1 beschriebenen Ausführungsform eine gemeinsame Beschichtungskammer 15 für zwei Beschichtungsplätze 12 und 14 vorgesehen. Dazu weist das Hülsenteil 19 nicht zwei getrennte Hülsen, wie im oben beschriebenen Ausführungsbeispiel, sondern vielmehr eine gemeinsame Hülse auf, welche sich beim Schließen über beide Werkstücke, beziehungsweise über beide Beschichtungsplätze stülpt. Dementsprechend benötigt die Beschichtungsvorrichtung auch nur einen Versorgungakanal 41 für die Evakuierung und Belüftung der Reaktorkammer oder Beschichtungskammer 15.

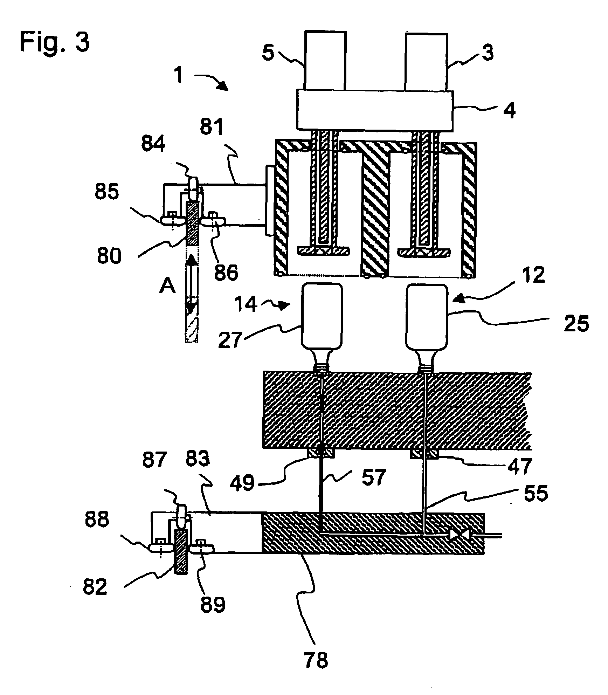

In Fig. 3 ist eine Querschnittansicht durch eine Ausführungsform der Erfindung dargestellt, bei welcher das Öffnen und Schließen der Beschichtungskammern durch mechanische Steuerkurven bewerkstelligt wird. Der Übersichtlichkeit halber sind in Fig. 3 die Zuführungskanäle, sowie die Pumpen und Regelventile nicht dargestellt.

Am Hülsenteil 19 der Beschichtungsvorrichtung 1 befindet sich ein Arm 81. Am Arm 81 sind Kurvenrollen 84, 85 und 86 angeordnet. Die Kurvenrollen 84, 85 und 86 umgreifen eine mechanische Steuerkurve 80, an welcher die Beschichtungsvorrichtung 1 in Transportrichtung vorbeigefahren wird. Die Steuerkurve 80 erstreckt sich ebenfalls entlang der Transportrichtung und ist in geeigneter Weise gebogen, so daß sich deren Querschnittsprofil entlang der Richtung A verschiebt. Dadurch wird beim Vorbeibewegen der Beschichtungsvorrichtung entlang der Steuerkurve der Arm und das mit diesem verbundene Hülsenteil 19 ebenfalls entlang der Richtung A bewegt, wodurch die Beschichtungskammern zum Einsetzen von Werkstücken in die Beschichtungsplätze 12 und 14 oder zum Herausnehmen der Werkstücke geöffnet und geschlossen werden.

In gleicher weise kann auch die Bewegung der Gaslanzen 55 und 57 gesteuert werden. Dazu sind die Gaslanzen an einem Träger 78 befestigt, an welchem ebenfalls ein Arm 83 angebracht ist. Der Arm 83 ist wiederum mit Kurvenrollen 87, 88 und 98 versehen, welche eine weitere mechanische Steuerkurve 82 umgreifen. Die Bewegung der Gaslanzen erfolgt in analoger Weise, wie oben anhand der Bewegung des Hülsenteils 19 beschrieben wurde. Die Kanäle im Sockelelement 33, in denen sich die Gaslanzen 55 und 57 bewegen, werden dabei durch dynamische Dichtungen 47 und 49 mit einer Leckrate < 0,1 mbar 1 /s gasdicht gegen Atmosphäre abgedichtet, so daß im Rahmen der Leckrate kein Gas aus der Umgebung in das Innere der hohlkörperförmigen Werkstücke 25 und 27 gelangen kann. Anders als in Fig. 3 dargestellt, können auch nicht dynamische, an den Gaslanzen 55, 57 befestigten Dichtungen 47, 49 mit axialem Dichtring verwendet werden, wie sie anhand von Fig. 1B beschrieben wurden.

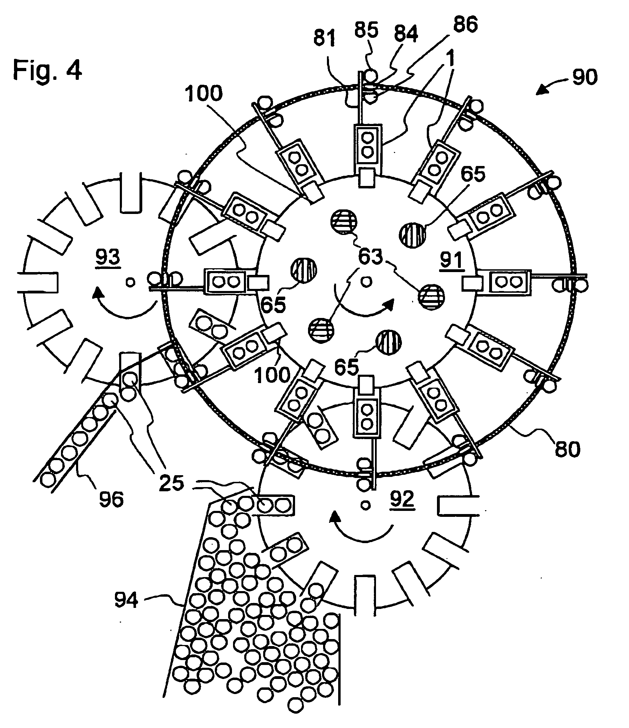

In Fig. 4 ist eine schematische Aufsicht auf eine Beschichtungsanlage 90 zum Beschichten von Werkstücken 25 dargestellt, die mit einer Vielzahl von erfindungsgemäßen Beschichtungsvorrichtungen 1 ausgestattet ist. Die Beschichtungsanlage 90 umfasst eine Rundlauf-Transporteinrichtung oder einen Rundläufer 91, an welchem beispielhaft zwölf der erfindungsgemäßen Beschichtungsvorrichtungen 1 angeordnet sind. Die Beschichtungsanlage umfasst ferner eine feststehend montierte Steuerkurve 80 zur Steuerung des Öffnungs- und Schließvorgangs der Beschichtungseinrichtungen 1.

Die Beschichtungseinrichtungen 1 weisen außerdem jeweils Arme 81 auf, die wie anhand von Fig. 3 dargestellt wurde, an den jeweiligen Hülsenteilen der Reaktoren befestigt sind und durch Vorbeibewegen an der Steuerkurve 80 bewegt werden.

Die Werkstücke 25 werden über eine Förderschiene 94 einem Zuteilrad oder Übergaberad 92 zugeführt, welches dann die Werkstücke zu den Beschichtungsplätzen der Beschichtungsvorrichtungen 1 transportiert. Die Werkstücke werden dann in geeigneten Aufnahmen in den Beschichtungsplätzen der Beschichtungsvorrichtungen 1 fixiert. Bei Drehung des Rundläufers werden die Hülsenteile durch Vorbeibewegen an der Steuerkurve 80 wie oben beschrieben geschlossen und die Beschichtungskammern der Reaktoren evakuiert. Im Falle hohlkörperförmiger Werkstücke können dann ebenfalls über eine Steuerkurve gesteuert Gaslanzen in die Werkstücke eingeführt werden. Daraufhin wird Prozessgas eingelassen und die Beschichtung durch Einstrahlung von Mikrowellen vorgenommen, während sich der Rundläufer 91 weiterdreht.

Die Zuführung von Prozeßgas, das Belüften und Evakuieren der Beschichtungskammern der Beschichtungsvorrichtungen 1 wird über Ventilblöcke 100 gesteuert, die zusammen mit den Beschichtungsvorrichtungen auf dem Rundläufer angeordnet sind und mitrotieren. Bei dieser Ausführungsform einer Beschichtungsanlage 90 sind außerdem auch Pumpeinrichtungen 63, 65 mitrotierend auf dem Rundläufer angeordnet, die über Zuleitungen mit den Ventilblöcken 100 zur Vakuumversorgung der Beschichtungskammern mit den Ventilblöcken verbunden sind. Zusätzlich können auch eine oder mehrere Pumpeinrichtungen vorhanden sein, die fest angeordnet sind und über eine Drehzuführung mit den Ventilblöcken verbunden sind.

Eine derartige Anordnung mit mitrotierenden Pumpeinrichtungen und Ventilen, wie sie prinzipiell anhand von Fig. 4 dargestellt wurde, ist auch in der deutschen Patentanmeldung mit der Anmeldenummer 102 53 512.4-45 beschrieben, deren Offenbarung somit vollumfänglich auch zum Gegenstand der vorliegenden Erfindung gemacht wird.

Nach abgeschlossener Behandlung der Werkstücke werden dann, wieder vermittelt durch die Steuerkurve 80, die Hülsenteile der Beschichtungsvorrichtungen 1 angehoben und die Kammern geöffnet, woraufhin die beschichteten Werkstücke 25 von einem Förderrad 93 abgenommen und einer Transportschiene 96 für den Weitertransport zugeführt werden.

### Bezugszeichenliste

- 1: Beschichtungsvorrichtung
- 2: Einrichtung zur Einleitung elektromagnetischer Energie
- 3, 5: Mikrowellenköpfen
- 6, 8: Öffnungen in Hülsenteil
- 7, 9: Zuführungsleiter, Koaxialleiter
- 11, 13: dielektrische Fenster
- 12, 14: Beschichtungsplätze
- 15, 17: Beschichtungskammer
- 18: Reaktor
- 19: Hülsenteil
- 21, 23, 29, 31, 47, 49, 51, 53: Dichtungen
- 22, 24: Innenraum hohlkörperförmiger Werkstücke
- 25, 27: Werkstücke
- 26: Mündungsöffnung von 25, 27
- 33: Sockelelement
- 35, 37, 39, 41, 43, 45, 46: Versorgungskanäle
- 54: Halteelement
- 55, 57: Gaslanze
- 60, 61, 62, 64, 66, 73, 74, 77: Ventil
- 63, 65, 67, 69: Pumpeinrichtungen
- 71, 91: Dichtungskragen
- 75: Bypass-Leitung
- 78: Träger für Gaslanzen
- 80, 82: mechanische Steuerkurven
- 81, 82: Führungsarm
- 84 - 89: Kurvenrollen
- 90: Beschichtungsanlage
- 92, 93: Zuteilrad
- 94, 96: Förderschiene
- 100: Ventilblock
- 103: Pneumatik-Verteilungseinrichtung
- 130: Unterschneidung
- 131: Einführöffnung

## Patentansprüche

1. Beschichtungsvorrichtung (1) zur Plasmabeschichtung von Werkstücken (25, 27) mit
- einem Reaktor (18) mit einem Hülsenteil (19) und einem Sockelelement (33), wobei in aneinandergefügter Position zumindest eine abgedichtete Beschichtungskammer (15, 17) zwischen Hülsenteil (19) und Sockelelement (33) definiert wird, sowie
- einer Einrichtung (2) zur Einleitung elektromagnetischer Energie in die zumindest eine Beschichtungskammer (15, 17),
**dadurch gekennzeichnet, dass**
der Reaktor (18) zumindest zwei Beschichtungsplätze (12, 14) aufweist und
das Hülsenteil beweglich ist.

2. Beschichtungsvorrichtung (1) nach Anspruch 1, **gekennzeichnet durch** eine Führung für eine im wesentlichen senkrechten Bewegung des Hülsenteils zum Sockelelement (33) zum Öffnen und Verschließen der Beschichtungskammer (15, 17).

3. Beschichtungsvorrichtung (1) nach Anspruch 1 oder 2, **dadurch gekennzeichnet, dass** das Sockelelement Versorgungskanäle (35, 37, 39, 41, 43, 45) zur Evakuierung und/oder Belüftung und/oder Zuführung von Prozessgas aufweist.

4. Beschichtungsvorrichtung (1) nach einem der Ansprüche 1 bis 3, **dadurch gekennzeichnet, dass** zumindest zwei voneinander getrennte Beschichtungskammern (15, 17) zwischen Hülsenteil (19) und Sockelelement (33) gebildet werden.

5. Beschichtungsvorrichtung (1) nach einem der Ansprüche 1 bis 3, **dadurch gekennzeichnet, dass** eine gemeinsame Beschichtungskammer (15, 17) für zumindest zwei Beschichtungsplätze zwischen Hülsenteil (19) und Sockelelement (33) gebildet wird.

6. Beschichtungsvorrichtung (1) nach einem der Ansprüche 1 bis 5, **dadurch gekennzeichnet, daß** das Hülsenteil (2) zumindest eine Öffnung (6, 8) aufweist, in welche ein Zuführungsleiter (9, 7) der Einrichtung (2) zur Einleitung elektromagnetischer Energie eingreift.

7. Beschichtungsvorrichtung (1) nach Anspruch 6, **dadurch gekennzeichnet, daß** der zumindest eine Zuführungsleiter einen Hohlleiter und/oder einen Koaxialleiter umfaßt.

8. Beschichtungsvorrichtung (1) nach Anspruch 6 oder 7, **dadurch gekennzeichnet, daß** das Hülsenteil (2) zum Öffnen und Schließen der Beschichtungskammer (15, 17) entlang des zumindest einen Zuführungsleiter beweglich ist.

9. Beschichtungsvorrichtung (1) nach einem der Ansprüche 1 bis 8, **dadurch gekennzeichnet, daß** die Einrichtung (2) zur Einleitung elektromagnetischer Energie zumindest eine Einrichtung zur Erzeugung von elektromagnetischer Energie umfaßt.

10. Beschichtungsvorrichtung (1) nach Anspruch 9, **dadurch gekennzeichnet, daß** die Einrichtung zur Erzeugung von elektromagnetischer Energie zumindest einen Mikrowellenkopf (3, 5) umfaßt.

11. Beschichtungsvorrichtung nach einem der Ansprüche 1 bis 10, **dadurch gekennzeichnet, daß** die Einrichtung (2) zur Einleitung elektromagnetischer Energie zumindest eine Einrichtung (10) zur Aufteilung der elektromagnetischen Energie umfaßt.

12. Beschichtungsvorrichtung (1) nach Anspruch 9, 10 oder 11, **dadurch gekennzeichnet, daß** die Einrichtung zur Erzeugung von elektromagnetischer Energie eine Einrichtung zur Erzeugung gepulster elektromagnetischer Energie umfaßt.

13. Beschichtungsvorrichtung (1) nach einem der Ansprüche 1 bis 12, **dadurch gekennzeichnet, daß** die Beschichtungsplätze (12, 14) zur Aufnahme hohlkörperförmiger Werkstücke (12, 14), insbesondere zur Aufnahme von Flaschen, Ampullen, Kalotten oder Glühbirnenkörpern ausgebildet sind.

14. Beschichtungsvorrichtung (1) nach Anspruch 13, **dadurch gekennzeichnet, daß** die Beschichtungsplätze (12, 14) Dichtungen (51, 53) zur Abdichtung des Innenraums (22, 24) der hohlkörperförmigen Werkstücke (25, 27) aufweisen.

15. Beschichtungsvorrichtung (1) nach Anspruch 13 oder 14, **dadurch gekennzeichnet, daß** das Sockelelement separate Versorgungskanäle (35, 37, 39, 41, 43, 45) zur Evakuierung und/oder Belüftung und/oder Zuführung von Prozeßgas für den Innenraum (22, 24) und die Umgebung der hohlkörperförmigen Werkstücke (25, 27) aufweist.

16. Beschichtungsvorrichtung (1) nach Anspruch 15, **dadurch gekennzeichnet, daß** die Versorgungskanäle (37, 39, 43, 45) zwei oder mehrerer Beschichtungsplätze (12, 14) über gemeinsamer weitere Versorgungskanäle (35, 41) oder Versorgungsleitungen zusammengeschaltet sind.

17. Beschichtungsvorrichtung (1) nach einem der Ansprüche 1 bis 16, **dadurch gekennzeichnet, daß** die Zuführung von Prozeßgas zu einer Beschichtungskammer (15, 17) über zumindest eine Gaslanze (55, 57) erfolgt.

18. Beschichtungsvorrichtung (1) nach einem der Ansprüche 1 bis 17, **dadurch gekennzeichnet, daß** die Bewegung zum Öffnen und Schließen des Hülsenteils (19) und/oder einer Gaslanze (55, 57) über mechanische Steuerkurven (80, 82) vermittelt wird.

19. Verfahren zur Plasmabeschichtung von Werkstücken (25, 27) in einer Beschichtungsvorrichtung (1) oder einer Beschichtungsanlage insbesondere gemäß einem der vorstehenden Ansprüche, mit einem Reaktor (18) mit einem beweglichen Hülsenteil (19) und einem Sockelelement (33), wobei
- zumindest zwei zu beschichtende Werkstücke (25, 27) auf dem Sockelelement (33) angeordnet werden,
- das Hülsenteil (19) mit dem Sockelelement (33) zusammengeführt werden, so daß in zusammengefügter Position zumindest eine abgedichtete Beschichtungskammer (15, 17) zwischen Hülsenteil (19) und Sockelelement (33) definiert wird, in welcher sich wenigstens eines der Werkstücke (25, 27) befindet,
- die Beschichtungskammer (15, 17) evakuiert,
- Prozeßgas eingeleitet, und
- ein Plasma durch Einleiten elektromagnetischer Energie erzeugt wird,
**dadurch gekennzeichnet, daß** das Hülsenteil (19) mit dem Sockelelement (33) durch Bewegen des Hülsenteils zusammengeführt wird.

20. Verfahren nach Anspruch 19, **dadurch gekennzeichnet, dass** das Hülsenteil zum Öffnen und Verschließen der Beschichtungskammer (15, 17) im wesentlichen senkrecht zum Sockelelement (33) bewegt wird.

21. Verfahren nach Anspruch 19 oder 20, **dadurch gekennzeichnet, dass** das Evakuieren und/oder Belüftung und/oder das Zuführen von Prozessgas durch Versorgungskanäle (35, 37, 39, 41, 43, 45) im Sockelelement erfolgt.

22. Verfahren gemäß einem der vorstehenden Ansprüche, **dadurch gekennzeichnet, daß** ein gepulstes Plasma durch Zuführen gepulster elektromagnetischer Energie erzeugt wird.

23. Verfahren gemäß einem der vorstehenden Ansprüche, **dadurch gekennzeichnet, daß** das Hülsenteil (2) zum Öffnen und Schließen der Beschichtungskammer (15, 17) entlang zumindest eines Zuführungsleiter zur Zuführung elektromagnetischer Energie bewegt wird.

24. Verfahren gemäß einem der vorstehenden Ansprüche zur Beschichtung hohlkörperförmiger Werkstücke, **dadurch gekennzeichnet, daß** die Umgebung und der Innenraum der Werkstücke getrennt evakuiert werden.

25. Verfahren gemäß einem der vorstehenden Ansprüche, zur Beschichtung hohlkörperförmiger Werkstücke, **dadurch gekennzeichnet, daß** in den Innenraum (22, 24) der Werkstücke (25, 27) Prozeßgas eingeleitet wird.

26. Verfahren gemäß einem der vorstehenden Ansprüche, **dadurch gekennzeichnet, daß** das Evakuieren der Beschichtungskammer schrittweise in zumindest zwei Druckstufen erfolgt.

27. Verfahren gemäß einem der vorstehenden Ansprüche, zur Beschichtung hohlkörperförmiger Werkstücke (25, 27), **dadurch gekennzeichnet, daß** zum Evakuieren der Beschichtungskammer (15, 17) der Innenraum der Werkstücke (22 ,24) bis zu einem Basisdruck < 0,1mbar und die Umgebung der Werkstücke (15, 17) entweder ebenfalls auf den Basisdruck oder auf einen festen Außendruck zwischen 1 und 100mbar abgepumpt wird.

28. Verfahren gemäß einem der vorstehenden Ansprüche, **dadurch gekennzeichnet, daß** die Einleitung von Prozessgas in eine Beschichtungskammer (15, 17) über zumindest eine Gaslanze (55, 57) erfolgt.

29. Verfahren gemäß einem der vorstehenden Ansprüche, **dadurch gekennzeichnet, daß** das Einleiten elektromagnetischer Energie das Einleiten von Mikrowellen umfaßt.

30. Verfahren gemäß einem der vorstehenden Ansprüche, **dadurch gekennzeichnet, daß** das Bewegen des Hülsenteils (19) über mechanische Steuerkurven (80, 82) vermittelt wird.

## Claims

1. Coating device (1) for the plasma coating of workpieces (25, 27) having
- a reactor (18) having a sleeve part (19) and a socket member (33), wherein in the joined position at least one sealed coating chamber (15, 17) is defined between the sleeve part (19) and the socket member (33), and
- a device (2) for introducing electromagnetic energy into the at least one coating chamber (15, 17),
**characterised in that**
the reactor (18) comprises at least two coating stations (12, 14), and
the sleeve part is movable.

2. Coating device (1) as claimed in Claim 1, **characterised by** a guide for a substantially perpendicular movement of the sleeve part with respect to the socket member (33) in order to open and close the coating chamber (15, 17).

3. Coating device (1) as claimed in Claim 1 or 2, **characterised in that** the socket member comprises supply channels (35, 37, 39, 41, 43, 45) to vent and/or aerate and/or supply process gas.

4. Coating device (1) as claimed in any one of Claims 1 to 3, **characterised in that** at least two mutually separate coating chambers (15, 17) are formed between the sleeve part (19) and the socket member (33).

5. Coating device (1) as claimed in any one of Claims 1 to 3, **characterised in that** a common coating chamber (15, 17) for at least two coating stations is formed between the sleeve part (19) and the socket member (33).

6. Coating device (1) as claimed in any one of Claims 1 to 5, **characterised in that** the sleeve part (2) comprises at least one aperture (6, 8) into which a supply lead (9, 7) of the device (2) for introducing electromagnetic energy engages.

7. Coating device (1) as claimed in Claim 6, **characterised in that** the at least one supply lead includes a hollow lead and/or a coaxial lead.

8. Coating device (1) as claimed in Claim 6 or 7, **characterised in that** the sleeve part (2) is movable along the at least one supply lead in order to open and close the coating chamber (15, 17).

9. Coating device (1) as claimed in any one of Claims 1 to 8, **characterised in that** the device (2) for introducing electromagnetic energy includes at least one device for producing electromagnetic energy.

10. Coating device (1) as claimed in Claim 9, **characterised in that** the device for producing electromagnetic energy includes at least one microwave head (3, 5).

11. Coating device as claimed in any one of Claims 1 to 10, **characterised in that** the device (2) for introducing electromagnetic energy includes at least one device (10) for splitting the electromagnetic energy.

12. Coating device (1) as claimed in Claim 9, 10 or 11, **characterised in that** the device for producing electromagnetic energy includes a device for producing pulsed electromagnetic energy.

13. Coating device (1) as claimed in any one of Claims 1 to 12, **characterised in that** the coating stations (12, 14) are formed to receive hollow body-shaped workpieces (12, 14), in particular for receiving bottles, ampoules, spherical caps or bulb bodies.

14. Coating device (1) as claimed in Claim 13, **characterised in that** the coating stations (12, 14) comprise seals (51, 53) for sealing the interior (22, 24) of the hollow body-shaped workpieces (25, 27).

15. Coating device (1) as claimed in Claim 13 or 14, **characterised in that** the socket member comprises separate supply channels (35, 37, 39, 41, 43, 45) for venting and/or aerating and/or supplying process gas for the interior (22, 24) and the surrounding environment of the hollow body-shaped workpieces (25, 27).

16. Coating device (1) as claimed in Claim 15, **characterised in that** the supply channels (37, 39, 43, 45) of two or more coating stations (12, 14) are interconnected via common further supply channels (35, 41) or supply lines.

17. Coating device (1) as claimed in any one of Claims 1 to 16, **characterised in that** the process gas is supplied to a coating chamber (15, 17) via at least one gas lance (55, 57).

18. Coating device (1) as claimed in any one of Claims 1 to 17, **characterised in that** the movement for opening and closing the sleeve part (19) and/or a gas lance (55, 57) is transmitted via mechanical cams (80, 82).

19. Method for the plasma coating of workpieces (25, 27) in a coating device (1) or a coating apparatus in particular as claimed in any one of the preceding Claims, having a reactor (18) having a movable sleeve part (19) and a socket member (33), wherein
- at least two workpieces (25, 27) to be coated are disposed on the socket member (33),
- the sleeve part (19) and the socket member (33) are brought together so that in the joined position at least one sealed coating chamber (15, 17) is defined between the sleeve part (19) and the socket member (33), in which at least one workpiece (25, 27) is located,
- the coating chamber (15, 17) is vented,
- process gas is introduced, and
- plasma is produced by introducing electromagnetic energy,
**characterised in that** the sleeve part (19) is brought together with the socket member (33) by moving the sleeve part.

20. Method as claimed in Claim 19, **characterised in that** the sleeve part is moved in a substantially perpendicular manner with respect to the socket member (33) in order to open and close the coating chamber (15, 17).

21. Method as claimed in Claim 19 or 20, **characterised in that** the venting and/or aerating and/or supplying of process gas is effected via supply channels (35, 37, 39, 41, 43, 45) in the socket member.

22. Method as claimed in any one of the preceding Claims, **characterised in that** pulsed plasma is produced by supplying pulsed electromagnetic energy.

23. Method as claimed in any one of the preceding Claims, **characterised in that** in order to open and close the coating chamber (15, 17) the sleeve part (2) is moved along at least one supply lead for supplying electromagnetic energy.

24. Method as claimed in any one of the preceding Claims for coating hollow body-shaped workpieces, **characterised in that** the surrounding environment and the interior of the workpieces are vented separately.

25. Method as claimed in any one of the preceding Claims for coating hollow body-shaped workpieces, **characterised in that** process gas is introduced into the interior (22, 24) of the workpieces (25, 27).

26. Method as claimed in any one of the preceding Claims, **characterised in that** the coating chamber is vented in stages in at least two pressure stages.

27. Method as claimed in any one of the preceding Claims for coating hollow body-shaped workpieces (25, 27), **characterised in that** in order to vent the coating chamber (15, 17) the interior of the workpieces (22, 24) is pumped down to a base pressure of less than 0.1 mbar and the surrounding environment of the workpieces (15, 17) is pumped down to either the base pressure as well or to a fixed external pressure between 1 and 100 mbar.

28. Method as claimed in any one of the preceding Claims, **characterised in that** the process gas is introduced into a coating chamber (15, 17) via at least one gas lance (55, 57).

29. Method as claimed in any one of the preceding Claims, **characterised in that** the introduction of electromagnetic energy includes the introduction of microwaves.

30. Method as claimed in any one of the preceding Claims, **characterised in that** the movement of the sleeve part (19) is transmitted via mechanical cams (80, 82).

## Revendications

1. Dispositif de revêtement (1) pour le revêtement au plasma de pièces (25, 27), comportant :
- un réacteur (18) comportant une partie formant manchon (19) et un élément formant socle (33), au moins une chambre de revêtement étanche (15, 17) étant alors définie entre la partie formant manchon (19) et l'élément formant socle (33) en position jointe, et
- un dispositif (2) pour l'introduction d'énergie électromagnétique dans la au moins une chambre de revêtement (15, 17),
**caractérisé par le fait que** le réacteur (18) comporte au moins deux postes de revêtement (12, 14) et que la partie formant manchon est mobile.

2. Dispositif de revêtement (1) selon la revendication 1, **caractérisé par** un guide pour un déplacement globalement perpendiculaire de la partie formant manchon par rapport à l'élément formant socle (33) pour l'ouverture et la fermeture de la chambre de revêtement (15, 17).

3. Dispositif de revêtement (1) selon la revendication 1 ou 2, **caractérisé par le fait que** l'élément formant socle comporte des canaux d'alimentation (35, 37, 39, 41, 43, 45) pour faire le vide et/ou aérer et/ou amener un gaz de processus.

4. Dispositif de revêtement (1) selon l'une des revendications 1 à 3, **caractérisé par le fait qu'**au moins deux chambres de revêtement (15, 17) séparées l'une de l'autre sont formées entre la partie formant manchon (19) et l'élément formant socle (33).

5. Dispositif de revêtement (1) selon l'une des revendications 1 à 3, **caractérisé par le fait qu'**une chambre de revêtement commune (15, 17) est formée pour au moins deux postes de revêtement entre la partie formant manchon (19) et l'élément formant socle (33).

6. Dispositif de revêtement (1) selon l'une des revendications 1 à 5, **caractérisé par le fait que** la partie formant manchon (2) comporte au moins une ouverture (6, 8) dans laquelle pénètre un guide d'amenée (9, 7) du dispositif (2) pour l'introduction d'énergie électromagnétique.

7. Dispositif de revêtement (1) selon la revendication 6, **caractérisé par le fait que** l'au moins un guide d'amenée comprend un guide d'onde et/ou un guide coaxial.

8. Dispositif de revêtement (1) selon la revendication 6 ou 7, **caractérisé par le fait que**, pour l'ouverture et la fermeture de la chambre de revêtement (15, 17), la partie formant manchon (2) est mobile le long d'au moins un guide d'amenée.

9. Dispositif de revêtement (1) selon l'une des revendications 1 à 8, **caractérisé par le fait que** le dispositif (2) pour l'introduction d'énergie électromagnétique comprend au moins un dispositif pour la production d'énergie électromagnétique.

10. Dispositif de revêtement (1) selon la revendication 9, **caractérisé par le fait que** le dispositif pour la production d'énergie électromagnétique comprend au moins une tête à micro-ondes (3, 5).

11. Dispositif de revêtement (1) selon l'une des revendications 1 à 10, **caractérisé par le fait que** le dispositif (2) pour l'introduction d'énergie électromagnétique comprend au moins un dispositif (10) pour la répartition de l'énergie électromagnétique.

12. Dispositif de revêtement (1) selon la revendication 9, 10 ou 11, **caractérisé par le fait que** le dispositif pour la production d'énergie électromagnétique comprend un dispositif pour la production d'énergie électromagnétique pulsée.

13. Dispositif de revêtement (1) selon l'une des revendications 1 à 12, **caractérisé par le fait que** les postes de revêtement (12, 14) sont conçus pour recevoir des pièces en forme de corps creux (12, 14), notamment pour recevoir des bouteilles, des ampoules, des calottes ou des corps de lampes à incandescence.

14. Dispositif de revêtement (1) selon la revendication 13, **caractérisé par le fait que** les postes de revêtement (12, 14) comportent des joints (51, 53) pour l'étanchéification de l'espace intérieur (22, 24) des pièces en forme de corps creux (25, 27).

15. Dispositif de revêtement (1) selon la revendication 13 ou 14, **caractérisé par le fait que** l'élément formant socle comporte des canaux d'alimentation séparés (35, 37, 39, 41, 43, 45) pour faire le vide et/ou aérer et/ou amener un gaz de processus pour l'espace intérieur (22, 24) et pour l'environnement des pièces en forme de corps creux (25, 27).

16. Dispositif de revêtement (1) selon la revendication 15, **caractérisé par le fait que** les canaux d'alimentation (37, 39, 43, 45) de deux ou plus de deux postes de revêtement (12, 14) sont branchés ensemble par l'intermédiaire d'autres canaux d'alimentation (35, 41) ou conduites d'alimentation communs.

17. Dispositif de revêtement (1) selon l'une des revendications 1 à 16, **caractérisé par le fait que** l'amenée de gaz de processus à une chambre de revêtement (15, 17) s'effectue par l'intermédiaire d'au moins une lance à gaz (55, 57).

18. Dispositif de revêtement (1) selon l'une des revendications 1 à 17, **caractérisé par le fait que** le déplacement pour l'ouverture et la fermeture de la partie formant manchon (19) et/ou d'une lance à gaz (55, 57) est réalisé par l'intermédiaire de cames de commande mécaniques (80, 82).

19. Procédé pour le revêtement au plasma de pièces (25, 27), dans un dispositif de revêtement (1) ou dans une installation de revêtement notamment selon l'une des revendications précédentes, avec un réacteur (18) comportant une partie formant manchon (19) et un élément formant socle (33),
- au moins deux pièces à revêtir (25, 27) étant placées sur l'élément formant socle (33),
- la partie formant manchon (19) étant réunie à l'élément formant socle (33) de telle sorte qu'au moins une chambre de revêtement étanche (15, 17) est définie entre la partie formant manchon (19) et l'élément formant socle (33) en position jointe, chambre de revêtement dans laquelle se trouve au moins l'une des pièces (25, 27),
- le vide étant fait dans la chambre de revêtement (15, 17),
- un gaz de processus étant introduit, et
- un plasma étant produit par introduction d'énergie électromagnétique,
**caractérisé par le fait que** l'on réunit la partie formant manchon (19) à l'élément formant socle (33) en déplaçant la partie formant manchon.

20. Procédé selon la revendication 19, **caractérisé par le fait que**, pour l'ouverture et la fermeture de la chambre de revêtement (15, 17), on déplace la partie formant manchon globalement perpendiculairement à l'élément formant socle (33).

21. Procédé selon la revendication 19 ou 20, **caractérisé par le fait que** faire le vide et/ou aérer et/ou amener un gaz de processus s'effectue via des canaux d'alimentation (35, 37, 39, 41, 43, 45) dans l'élément formant socle.

22. Procédé selon l'une des revendications précédentes, **caractérisé par le fait que** l'on produit un plasma pulsé par amenée d'énergie électromagnétique pulsée.

23. Procédé selon l'une des revendications précédentes, **caractérisé par le fait que**, pour l'ouverture et la fermeture de la chambre de revêtement (15, 17), on déplace la partie formant manchon (2) le long d'au moins un guide d'amenée pour l'amenée d'énergie électromagnétique.

24. Procédé selon l'une des revendications précédentes, pour le revêtement de pièces en forme de corps creux, **caractérisé par le fait que** l'on fait le vide séparément dans l'environnement et dans l'espace intérieur des pièces.

25. Procédé selon l'une des revendications précédentes, **caractérisé par le fait que** l'on introduit un gaz de processus dans l'espace intérieur (22, 24) des pièces (25, 27).

26. Procédé selon l'une des revendications précédentes, **caractérisé par le fait que** l'on fait le vide dans la chambre de revêtement progressivement en au moins deux niveaux de pression.

27. Procédé selon l'une des revendications précédentes, pour le revêtement de pièces en forme de corps creux (25, 27), **caractérisé par le fait que**, pour faire le vide dans la chambre de revêtement (15, 17), on vide par pompe l'espace intérieur (22, 24)des pièces jusqu'à une pression de base < 0,1 mbar et l'environnement des pièces (15, 17) soit également jusqu'à la pression de base soit jusqu'à une pression extérieure fixe comprise entre 1 et 100 mbar.

28. Procédé selon l'une des revendications précédentes, **caractérisé par le fait que** l'on introduit un gaz de processus dans une chambre de revêtement (15, 17) par l'intermédiaire d'au moins une lance à gaz (55, 57).

29. Procédé selon l'une des revendications précédentes, **caractérisé par le fait que** l'introduction d'énergie électromagnétique comprend l'introduction de micro-ondes.

30. Procédé selon l'une des revendications précédentes, **caractérisé par le fait que** l'on réalise le déplacement de la partie formant manchon (19) par l'intermédiaire de cames de commande mécaniques (80, 82).
